(19) Europäisches Patentamt
European Patent Office
Office européen des brevets

(11) **EP 2 318 851 B1**

(12) **EUROPÄISCHE PATENTSCHRIFT**

(45) Veröffentlichungstag und Bekanntmachung des Hinweises auf die Patenterteilung:
**07.05.2014  Patentblatt 2014/19**

(21) Anmeldenummer: **09777941.7**

(22) Anmeldetag: **18.08.2009**

(51) Int Cl.:
*G01N 21/64* [(2006.01)]        *G01R 31/265* [(2006.01)]
*G01R 31/26* [(2014.01)]

(86) Internationale Anmeldenummer:
**PCT/EP2009/005973**

(87) Internationale Veröffentlichungsnummer:
**WO 2010/022874 (04.03.2010 Gazette 2010/09)**

(54) **VERFAHREN ZUR BESTIMMUNG DER REKOMBINATIONSEIGENSCHAFTEN AN EINEM MESSTEILBEREICH EINER MESSSEITE EINER HALBLEITERSTRUKTUR**

METHOD FOR DETERMINING THE RECOMBINATION PROPERTIES AT A MEASURING SECTION OF A MEASURING SIDE OF A SEMICONDUCTOR STRUCTURE

PROCÉDÉ PERMETTANT DE DÉTERMINER LES PROPRIÉTÉS DE RECOMBINAISON AU NIVEAU D'UNE ZONE PARTIELLE DE MESURE D'UN CÔTÉ DE MESURE D'UNE STRUCTURE SEMI-CONDUCTRICE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **29.08.2008   DE 102008044884**

(43) Veröffentlichungstag der Anmeldung:
**11.05.2011   Patentblatt 2011/19**

(73) Patentinhaber:
• **Fraunhofer-Gesellschaft zur Förderung der angewandten Forschung e.V.
80686 München (DE)**
• **Albert-Ludwigs-Universität Freiburg
79085 Freiburg (DE)**

(72) Erfinder:
• **KASEMANN, Martin
79211 Denzlingen (DE)**
• **HERMLE, Martin
79117 Freiburg (DE)**
• **GRANEK, Filip
79110 Freiburg (DE)**

(56) Entgegenhaltungen:
**EP-A1- 0 206 363      WO-A1-2008/014537
US-A- 5 406 214**

• WÜRFEL P ET AL: "Diffusion lengths of silicon solar cells from luminescence images" JOURNAL OF APPLIED PHYSICS, Bd. 101, 27. Juni 2007 (2007-06-27), Seiten 123110-1, XP002552875 in der Anmeldung erwähnt
• HERMLE M ET AL: "Analyzing the effects of front-surface fields on back-junction silicon solar cells using the charge-collection probability and the reciprocity theorem" JOURNAL OF APPLIED PHYSICS, AMERICAN INSTITUTE OF PHYSICS. NEW YORK, US, Bd. 103, Nr. 5, 10. März 2008 (2008-03-10) , Seiten 54507-54507, XP012109500 ISSN: 0021-8979
• M.P GODLEWSKI, C.R. BARAONA, H.W. BRANDHORST JR.: "Low-high junction theory applied to solar cells" PROCEEDINGS OF THE 10TH IEEE PHOTOVOLTAIC SPECIALISTS CONFERENCE, PALO ALTO, CALIFORNIA, USA, 13. November 1973 (1973-11-13), - 15. November 1973 (1973-11-15) XP008115520
• METZGER ET AL: "How lifetime fluctuations, grain-boundary recombination, and junctions affect lifetime measurements and their correlation to silicon solar cell performance" SOLAR ENERGY MATERIALS AND SOLAR CELLS, ELSEVIER SCIENCE PUBLISHERS, AMSTERDAM, NL, Bd. 92, Nr. 9, 1. September 2008 (2008-09-01), Seiten 1123-1135, XP022735461 ISSN: 0927-0248 [gefunden am 2008-05-27]

- **PYSCH ET AL: "A review and comparison of different methods to determine the series resistance of solar cells" SOLAR ENERGY MATERIALS AND SOLAR CELLS, ELSEVIER SCIENCE PUBLISHERS, AMSTERDAM, NL, Bd. 91, Nr. 18, 30. August 2007 (2007-08-30), Seiten 1698-1706, XP022223139 ISSN: 0927-0248 in der Anmeldung erwähnt**
- **SINTON R A ET AL: "Quasi-steady-state photoconductance, a new method for solar cell material and device characterization" 19960513; 19960513 - 19960517, 13. Mai 1996 (1996-05-13), Seiten 457-460, XP010208187 in der Anmeldung erwähnt**
- **JOHNSON E O: "Measurement of minority carrier lifetimes with the surface photovoltage" JOURNAL OF APPLIED PHYSICS,, Bd. 28, Nr. 11, 1. November 1957 (1957-11-01), Seiten 1349-1353, XP002552874 in der Anmeldung erwähnt**

**Beschreibung**

Die Erfindung betrifft ein Verfahren zur Bestimmung der Rekombinationseigenschaften an einem Messteilbereich einer Messseite einer Halbleiterstruktur.

Zur Charakterisierung von Halbleiterstrukturen und insbesondere von Solarzellen sind verschiedene Methoden bekannt, mit denen Ladungsträgerlebensdauern in der Halbleiterstruktur und/oder Rekombinationseigenschaften an den Oberflächen der Halbleiterstruktur bestimmt werden:

Zur Bestimmung der Lebensdauer von Minoritätsladungsträgern in einem Halbleitermaterial sind verschiedene Apparaturen und Methoden bekannt, beispielsweise durch Messung des mikrowellendetektierten Photoleitfähigkeitsabklingen (MWPCD), welches in US 5,406,214 beschreiben ist, oder mittels der quasistatischen Photoleitfähigkeitsmethode (QSSPC), welche in R.A. Sinton, A.Cuevas und M . Stuckings in "Quasi-steady-state photoconductance, a new method for solar cell material and device characterization" in Proceedings for the 25th IEE Photovoltaic Specialists Conference, Washington DC, USA (1996) beschrieben ist. Ein weiteres Beispiel einer bekannten Methode zur Lebensdauerbestimmung In Halbleitermateriallen ist die "Surface Photovoltage Method", welche in ("Measurement of Minority Carrier Lifetimes with the Surface Photovoltage" von E.O. Johnson, Journal of Applied Physics, Volume 28, Number 11, S. 1349-53) beschrieben ist.

Ebenso ist es bekannt, bei Halbleiterstrukturen, die auf einem indirekten Halbleiter wie beispielsweise Silizium basieren, anhand einer in der Halbleiterstruktur erzeugten Lumineszenzstrahlung einen Zusammenhang der Materialqualität der Halbleiterstruktur und der Oberflächeneigenschaften der Halbleiterstruktur zu bestimmen. Bei bekannten Oberflächeneigenschaften wie beispielsweise den Rekombinationsgeschwindigkeiten an den Oberflächen ist es somit möglich, durch Messen der Lumineszenzstrahlung die Diffusionslänge der Minoritätsladungsträger zu bestimmen. Typischerweise wird bei der vorbekannten Methode mittels Messung der Lumineszenzstrahlung der Zusammenhang der Diffusionslänge der Minoritätsladungsträger und der Oberflächenrekombinationsgeschwindigkeit der Vorder- und/oder Rückseite des Halbleiters anhand von zwei Auswertungen der gemessenen Intensität zur Lumineszenzstrahlung bestimmt. Die beiden Auswertungen unterscheiden sich in der spektralen Gewichtung bezüglich der bei der jeweiligen Auswertung berücksichtigten Lumineszenzstrahlung. Ein solches Verfahren ist beispielsweise in Würfel, T. et al, "Diffusions lengths of silicon solar cel/s from luminescence images", journal of applied physics, 2007. 101 (123110): p.1-10 beschrieben. Weiterhin Ist solch ein Verfahren in PCT/AU2007/001050 offenbart.

All diesen Methoden ist gemeinsam, dass in der Halbleiterstruktur die Überschussladungsträgerdichte bestimmt wird oder eine zumindest qualitativ mit der Überschussladungsträgerdichte korrespondierende Größe.

Häufig ist an Halbleiterstrukturen, die ein fertig prozessiertes Bauelement oder ein teilweise prozessiertes Bauelement darstellen die Rekombinationseigenschaft in einem Teilbereich einer Oberfläche der Halbleiterstruktur von Interesse.

Dies ist beispielsweise bei solchen Solarzellen der Fall, bei denen eine Seite der Solarzelle lediglich teilweise mit einem Emitter bedeckt ist, denn insbesondere bei solchen Solarzellenstrukturen wird die Leistungsausbeute der gesamten Solarzelle signifikant von der Rekombinationseigenschaft des nicht durch dem Emitter bedeckten Teilbereichs dieser Oberfläche der Halbleiterstruktur begrenzt. Die Kenntnis der Rekombinationseigenschaft in diesem Teilbereich der Oberfläche ist daher eine wichtige technologisch verwertbare Information. Insbesondere bei Rückseitenkontaktzellen, bei denen der sammelnde pn-Übergang an der Rückseite angeordnet ist, ist die effektive Rückseitenrekombinationsgeschwindigkeit im nicht durch einen Emitter bedeckten Bereich an der Rückseite der Solarzelle ein kritischer Parameter, da sie sowohl die erreichbare offene Klemmspannung wesentlich limitiert, als auch die für die Kurzschiussstromdichte wichtige Einsammelwahrscheinlichkeit begrenzt und somit signifikant für den Gesamtwirkungsgrad der Solarzelle ist.

Der vorliegenden Erfindung liegt daher die Aufgabe zugrunde, ein Verfahren zur Bestimmung der Rekombinationseigenschaften an einem Messteilbereich einer Messseite einer Halbleiterstruktur zu schaffen, wobei mittels des Verfahrens eine quantitative Information über die Oberflächenrekombinationseigenschaft bestimmter Grenzschichten auf indirekten oder direkten Halbleitern ermittelt werden soll.

Das erfindungsgemäße Verfahren bezieht sich dabei auf die Messung an einer Halbleiterstruktur mit folgendem Aufbau:

Die Halbleiterstruktur umfasst eine Basis und weist eine Messseite auf. Der Begriff "Messseite" bezeichnet hierbei eine Oberfläche, an der in einem Teilbereich dieser Oberfläche die Rekombinationseigenschaft bestimmt werden soll. Diese Oberfläche kann beispielsweise die Vorder- oder Rückseite der Halbleiterstruktur sein. Ebenso liegt es im Rahmen der Erfindung, dass die Halbleiterstruktur ein Mehrschichtsystem ist und beispielsweise an den Oberflächen zusätzliche Schichten, wie beispielsweise elektrisch passivierende Schichten und/oder Schichten zur Verbesserung der optischen Eigenschaften gegenüber auf die Oberfläche auftretender elektromagnetischer Strahlung umfasst. Der Begriff "Messseite" bezeichnet hierbei die Grenzfläche an oder gegebenenfalls innerhalb der Halbleiterstruktur, an der Ladungsträgerrekombination auftreten kann und ein Teilbereich existiert, dessen Rekombinationseigenschaft mit dem erfindungsgemäßen Verfahren bestimmt werden soll.

Die Messseite der Halbleiterstruktur weist daher mindestens einen Messteilbereich und einen Referenzteilbereich auf, wobei der Referenzteilbereich zur Zu- oder Abführung von Ladungsträgern ausgebildet ist, beispielsweise als diodenartiger Kontakt, insbesondere als Metall-Halbleiterkontakt.

Solch ein Referenzteilbereich ist durch eine teilweise mit einem Emitter bedeckte Messseite realisiert, so dass der Emitter mit der Basis der Halbleiterstruktur einen pn-Übergang ausbildet und vorteilhafterweise einen metallischen Kontakt zur Verbindung mit einem externen Stromkreis, d.h. zum Zu- oder Abführen von Ladungsträgern aufweist.

Wesentlich ist, dass die Messseite zusätzlich mindestens einen Messteilbereich aufweist, der kein Referenzteilbereich ist, d.h. nicht durch einen Emitter bedeckt ist. In diesem Messteilbereich wird die Rekombinationseigenschaft mit dem erfindungsgemäßen Verfahren bestimmt, wobei das Verfahren folgende Verfahrensschritte umfasst:

In einem Schritt A werden Überschussminoritätsladungsträger zumindest in der Basis der Halbleiterstruktur erzeugt.

Zur Erzeugung der Überschussminoritätsiadungsträger werden somit Elektron-Lochpaare zumindest in der Basis der Halbleiterstruktur generiert.

In einem Verfahrensschritt B wird die Überschussladungsträgerdichte in der Basis oder zumindest eine qualitativ mit der Überschussladungsträgerdichte korrespondierende Größe gemessen. Hierbei wird zumindest eine erste Messung $M_1$ an einem über dem Referenzteilbereich liegenden ersten Basisbereich und eine zweite Messung $M_2$ an einem über dem Messtellbereich liegenden zweiten Basisbereich durchgeführt. Die Messungen $M_1$ und $M_2$ könnten dabei zeitlich versetzt oder gleichzeitig ausgeführt werden.

Wie nachfolgend bei Schritt C erklärt, ist für das erfindungsgemäße Verfahren die quantitative Kenntnis der Überschussladungsträgerdichte gemäß einer normierten physikalischen Größe nicht notwendig, da für das erfindungsgemäße Verfahren lediglich ein Angleichen der Messwerte der ersten Messung im $M_1$ und der zweiten Messung $M_2$ relevant ist. Der Einfachheit halber wird im Folgenden der Begriff "Überschussladungsträgerdichte" verwendet. Dies umfasst jedoch ebenso eine lediglich qualitativ mit der Überschussladungsträgerdichte korrespondierende Größe.

Der Begriff "Basisbereich" bezeichnet hierbei einen Teilbereich der Basis, der hinsichtlich seiner Position und Begrenzung durch Messteilbereich und Referenzteilbereich der Messseite definiert wird:

Die Bezeichnung "über" hinsichtlich der Beschreibung von Basisbereichen bedeutet hierbei, dass ausgehend von der Messseite der Halbleiterstruktur, welche dem Messteilbereich zugehörig ist, im Wesentlichen der senkrecht zur Messseite über dem Messteilbereich liegende Basisbereich im Sinne dieser Anmeldung als über dem Messteilbereich liegend bezeichnet ist. Entsprechendes gilt für den über dem Referenzteilbereich liegenden Basisbereich.

Im Schritt B wird somit in einem Basisbereich über dem Referenzteilbereich einerseits und in einem Basisbereich über dem Messteilbereich andererseits jeweils die Überschussladungsträgerdichte gemessen.

In einem Verfahrensschritt C wird ein Stromfluss / in der Halbleiterstruktur bei einer äußeren Spannung V zwischen dem Referenzteilbereich und einem mit der Basis der Halbleiterstruktur verbundenen Basiskontakt erzeugt.

Der Stromfluss kann beispielsweise durch Anlegen einer äußeren Spannung erzeugt werden;

Die äußere Spannung wird dabei einerseits an den Referenzteilbereich und andererseits an einem mit der Basis der Halbleiterstruktur verbundenen Basiskontakt angelegt. Der Basiskontakt ist vorteilhafterweise als ohmscher Kontakt ausgebildet, insbesondere ist ein metallischer Basiskontakt vorteilhaft.

Insbesondere bei als Solarzellen ausgebildeten Halbleiterstrukturen kann der Stromfluss auch durch Beleuchtung der Solarzelle und elektrisch leitendes Verbinden von Referenzteilbereich und Basiskontakt erfolgen, beispielsweise durch einen externen ohmschen Widerstand. In diesem Fall wird der Stromfluss somit durch die Solarzelle selbst erzeugt und durch die Wahl des externen Widerstandes geregelt.

Wesentlich ist, dass der Stromfluss / oder die Spannung V derart gewählt wird, dass das Messergebnis der ersten Messung $M_1$ gleich dem Messergebnis der zweiten Messung $M_2$ ist. Dies kann durch Regelung der Stromflusses / oder durch Regelung der äußeren Spannung V erfolgen.

Wesentlich ist weiterhin, dass in Schritt C ein Wertepaar aus angelegter äußerer Spannung V und bei dieser Spannung fließendem Strom / bestimmt wird, bei dem unter der beschriebenen Bedingung das Messergebnis der ersten Messung $M_1$ gleich dem Messergebnis der zweiten Messung $M_2$ ist.

Dies kann dadurch geschehen, dass bei fortdauernder Durchführung der Messungen $M_1$ und $M_2$ die äußere Spannung variiert wird, bis die Messergebnisse der Messungen $M_1$ und $M_2$ übereinstimmen. Ebenso liegen andere Verfahren im Rahmen der Erfindung, wie beispielsweise das kontinuierliche Erhöhen der äußeren angelegten Spannung von einem vorgegebenen Startwert auf einen vorgegebenen Endwert, wobei während der Erhöhung kontinuierlich sowohl der Wert des Stromflusses $I$, als auch die Messwerte der Messungen $M_1$ und $M_2$ aufgezeichnet werden, so dass nach abgeschlossener Messung in einem anschließenden Auswerteschritt dasjenige Wertepaar aus äußerer Spannung und Stromfluss ermittelt werden kann, bei dem die Messwerte der Messungen $M_1$ und $M_2$ gleich sind.

Insbesondere bei Anwendung des erfindungsgemäßen Verfahrens bei Halbleiterstrukturen wie beispielsweise Solarzellen, die eine diodenartige Kennlinie aufweisen ist es vorteilhaft, wenn in einem Bereich der Kennlinie, in der der Strom bei variierender Spannung annähernd konstant ist, die Spannung V zur Angleichung der Messungen $M_1$ und $M_2$ variiert wird und in einem Bereich der Kennlinie, in der die Spannung bei variierendem Strom annähernd konstant ist, der Stromfluss $I$ zur Angleichung der Messungen $M_1$ und $M_2$ variiert wird.

In einem Schritt D werden schließlich die Rekombinationseigenschaften des Messteilbereiches der Halbleiteroberfläche abhängig von dem In Schritt C ermittelten Wertepaar der äußeren Spannung V und des bei dieser Spannung fließenden Stromes $I$ bestimmt.

Mit dem erfindungsgemäßen Verfahren ist es somit möglich, bei einer Halbleiterstruktur des beschriebenen Aufbaus durch Messung der Überschussladungsträgerdichte an mindestens zwei Bereichen in der Basis der Halbleiterstruktur und Abstimmen einer angelegten äußeren Spannung derart, dass die Messergebnisse der beiden Messungen der Überschussladungsträgerdichte übereinstimmen, die Rekombinationseigenschaften des Messteilbereiches aus den resultierenden Messgrößen zu berechnen.

Das erfindungsgemäße Verfahren ist hierbei sowohl auf eine p-dotierte Basis anwendbar und gegebenenfalls einen n-dotierten Emitter im Referenzteilbereich wie auch auf eine Umkehrung der Dotierung der Dotierungstypen, d.h. auf eine n-dotierte Basis und gegebenenfalls einen p-dotlerten Emitter Im Referenzteilbereich

Dem erfindungsgemäßen Verfahren liegt folgende Erkenntnis des Anmelders zugrunde:

Den verschiedenen Teilbereich an der Messseite der Halbleiterstruktur können zur Beschreibung der Rekombinationseigenschaften jeweils so genannte "effektive" Oberflächenrekombinationsgeschwindigkeiten zugeordnet werden. Diese effektiven Oberflächenrekombinationsgeschwindigkeiten sind ein Maß für die Rekombinationsintensität in diesem Teilbereich der Messseiten bei den jeweils vorliegenden Bedingungen, wie beispielsweise der in diesem Teilbereich vorliegenden Überschussladungsträgerdichte und eventuell lokal variierender Rekombinationseigenschaften innerhalb dieses Teilbereichs.

Durch Anlegen der äußeren Spannung und Erzeugen eines Stromflusses wird die effektive Oberflächenrekombinationsgeschwindigkeit im Referenzteilbereich variiert. Sofern in dem Basisbereich über dem Referenzteilbereich die gleiche Überschussladungsträgerdichte besteht wie in dem Basisbereich über dem Messteilbereich entspricht somit die effektive Oberflächenrekombinationsgeschwindigkeit im Messteilbereich der effektiven Oberflächenrekombinationsgeschwindigkeit im Referenzteilbereich.

Anhand des Wertepaares aus angelegter äußerer Spannung V und dem Stromfluss $I$ bei dieser Spannung kann die effektive Oberflächenrekombinationsgeschwindigkeit im Referenzteilbereich berechnet werden, welche wie zuvor ausgeführt der effektiven Oberflächenrekombinationsgeschwindigkeit des Messteilbereiches entspricht und damit die interessierende Ergebnisgröße ist.

Vorteilhafterweise werden im Verfahrensschritt A die Überschussminoritätsladungsträger durch Beaufschlagung der Halbleiterstruktur mit einer Anregungsstrahlung erzeugt. Insbesondere ist es vorteilhaft, durch ganzflächiges, homogenes Beleuchten einer Oberfläche der Halbleiterstruktur mit Anregungsstrahlung die Überschussminoritätsladungsträger zu erzeugen.

Dies ist insbesondere bei der Anwendung des erfindungsgemäßen Verfahrens zur Charakterisierung von Solarzellen vorteilhaft, da hier zum einen mindestens eine Seite der als Solarzelle ausgebildete Halbleiterstruktur zur Einkopplung elektromagnetischer Strahlung ausgebildet ist und darüber hinaus gängige Messaufbauten zur ganzflächigen, homogenen Beleuchtung der Solarzelle verwendet werden können.

In einer weiteren vorteilhaften Ausführungsform wird in Schritt B bei den Messungen $M_1$ und $M_2$ die Intensität der Lumineszenzstrahlung der jeweiligen Bereiche gemessen. Die Intensität der Lumineszenzstrahlung ist eine mit der Überschussladungsträgerdichte korrespondierende Größe. Darüber hinaus sind Messverfahren und Messvorrichtungen zur Messung der Intensität der Lumineszenzstrahlung bekannt, wie beispielsweise in Würfel, P. et al, "Diffusions lengths of silicon solar cells from luminescence images". Journal of Applied Physics, 2007. 101 (123110): p. 1-10 und in PCT/AU2007/001050 beschrieben. Hier kann bei Anwendung des erfindungsgemäßen Verfahrens somit auf vorbekannte Messverfahren und insbesondere Messaufbauten zurückgegriffen werden.

Das erfindungsgemäße Messverfahren liefert insbesondere genaue Messwerte bei Halbleiterstrukturen, bei denen der Referenzteilbereich der Halbleiteroberfläche durch einen Emitter bedeckt ist, zur Ausbildung eines pn-Übergangs mit der Basis der Halbleiterstruktur.

Vorteilhafterweise sind die Rekombinationseigenschaften im Messteilbereich und Referenzteilbereich abgesehen von den Rekombinationseigenschaften der Messteilseite gleich.

Insbesondere ist es vorteilhaft, dass die Basis der Halbleiterstruktur eine im Wesentlichen homogene Minoritätsiadungsträgeriebensdauer aufweist, denn inhomogene Lebensdauer in der Basis können eine Verfälschung des Ladungsträgerprofils der Überschussiadungsträger bewirken und somit sich verfälschend auf das Messergebnis auswirken.

Ebenso ist es vorteilhaft, dass die Halbleiterstruktur an der der Messseite gegenüberliegenden Seite im Wesentlichen homogene Rekombinationseigenschaften aufweist. Auch hier können inhomogene Rekombinationseigenschaften an der beschriebenen gegenüberliegenden Seite das Ladungsträgerprofil der Überschussladungsträger in der Basis beeinflussen und damit das Messergebnis verfälschen.

Das erfindungsgemäße Verfahren eignet sich insbesondere zur Charakterisierung von Rückseitenkontaktsolarzellen. Bei solchen Solarzellen sind sowohl Emitter-, als auch Basiskontakt an der Rückseite der Solarzelle angeordnet. Dadurch, dass beide Kontakte an der Rückseite der Solarzelle angeordnet sind, findet keine Abschattung auf der zur Lichteinkopplung ausgebildeten Vorderseite durch die metallischen Emitter- und Basiskontakte statt. Ebenso ist es jedoch notwendig, dass auf der Rückseite Teilbereiche durch den Emitter bedeckt sind und Teilbereiche zur Kontaktierung der Basis ausgebildet. Die Effektive Oberflächenrekombinationsgeschwindigkeit an den zur Kontaktierung der Basis ausgebildeten Bereichen stellt eine signifikante Größe für den Gesamtwirkungsgrad der Solarzelle dar. Mit dem erfindungsgemäßen Verfahren ist es somit erstmals möglich, in einfacher Weise die effektive Oberffächenrekombinationsgeschwindigkeit in diesem Teilbereich der Rückseite einer Rückseitenkontaktzelle zu bestimmen. Insbesondere ist es möglich, diese Bestimmung an einer fertig prozessierten Rückseitenkontaktzelle vorzunehmen, es ist somit keine speziell für die Messung gefertigte Teststruktur notwendig.

Die Untersuchungen des Anmelders haben ergeben, dass in Verfahrensschritt D die effektive Oberflächenrekombinationsgeschwindigkeit in dem Messteilbereich über eine analytische Formel bestimmbar ist. Vorteilhafterweise wird in Verfahrensschritt D daher die Rekombinationseigenschaften des Messteilbereichs der Halbleiteroberfläche durch Berechnen der Oberflächenrekombinationsgeschwindigkeit $S_{Mtb}$ Über folgende Formel A bestimmt:

$$S_{Mtb} = \frac{j\,N_D}{e\,n_i^2}\exp\left(-\frac{e\,V}{k\,T}\right) \quad \text{(Formel A)},$$

mit dem gemessenen, zwischen Referenzteilbereich und Basiskontakt fließenden *Stromdichte j [A/cm2]*, der Dotierkonzentration der Basis $N_D$ *[cm-3]*, der Elementarladung e *[C]*, der intrinsischen Ladungsträgerdichte $n_I$ *[cm-3]*, der zwischen Referenzteilbereich und Basiskontakt anliegenden äußeren Spannung V *[V]*, der Boltzmannkonstante k *[J/K]* und der Temperatur T *[K]* der Halbleiterstruktur.

Der Stromfluss in einer Halbleiterstruktur und insbesondere in einer Solarzelle wird unter anderem durch Serienwiderstände beeinflusst. Hierzu tragen Serienwiderstände in den metallischen Kontaktstrukturen, Kontaktwiderstände an der Verbindung zwischen metallischer Kontaktstruktur und Halbleiter, sowie Schichtwiderstände bei Stromfluss innerhalb der Halbleiterstruktur bei. Es ist bekannt, für eine vorgegebene Solarzelle einen Gesamtserienwiderstand zu bestimmen, beispielsweise durch Vergleich der im Dunkeln und unter Beleuchtung gemessenen Kennlinie der Solarzelle, wie z.B. in Pysch, D., A. Mette and S. W. Glunz, "A review and comparison of different methods to determine the series resistance of solar cells", Solar Energy Materials and Solar Cells, 2007, 91(18) p. 1698-1706 beschrieben.

Vorteilhafterweise wird im Verfahrensschritt D der Einfluss des Serienwiderstandes der Halbleiterstruktur berücksichtigt und entsprechend die Berechnung der Oberflächenrekombinationsgeschwindigkeit $S_{Mtb}$ gemäß Formel B durchgeführt:

$$S_{Mtb} = \frac{j\,N_D}{e\,n_i^2}\exp\left(-\frac{e\,(V + j\,R_S)}{k\,T}\right) \quad \text{(Formel B)}$$

Hierbei bezeichnen die Variablen die jeweils zu Formel A angegebenen Größen und zusätzlich weist die Formel den Serienwiderstand $R_S$ *[Ωcm2]* der Halbleiterstruktur auf.

Bei den eingangs erwähnten Messmethoden zur Bestimmung der Ladungsträgerdichte in einer Halbleiterstruktur sind so genannte "quasistatische" und so genannte "transiente" Messmethoden bekannt. Die quasistatischen Messmethoden zeichnen sich dadurch aus, dass sich Generation und Rekombination von Ladungsträger in einem quasistatischen Gleichgewicht befinden, wohingegen bei transienten Messungen eine stetige Veränderung der Ladungsträgerdichte erfolgt, typischerweise ein exponentieller Abfall.

Vorteilhafterweise werden die Messungen in Verfahrensschritt B derart durchgeführt, dass sich die Halbleiterstruktur in quasi-statischem Zustand befindet.

Weitere Merkmale und vorteilhafte Ausgestaltungen des erfindungsgemäßen Verfahrens werden im Folgenden anhand eines Ausführungsbeispiels und der Figuren beschrieben. Dabei zeigt:

Figur 1    einen schematischen Aufbau einer Rückseitenkontaktzelle und

Figur 2    ein vereinfachtes Modell des Aufbaus der Rückseitenkontaktzelle, welches zur Veranschaulichung der physikalischen Grundlagen des erfindungsgemäßen Verfahrens dient.

Wie zuvor beschrieben, zeichnet sich eine Rückseitenkontaktzelle dadurch aus, dass beide Kontakte an der Rückseite der Solarzelle angeordnet sind.

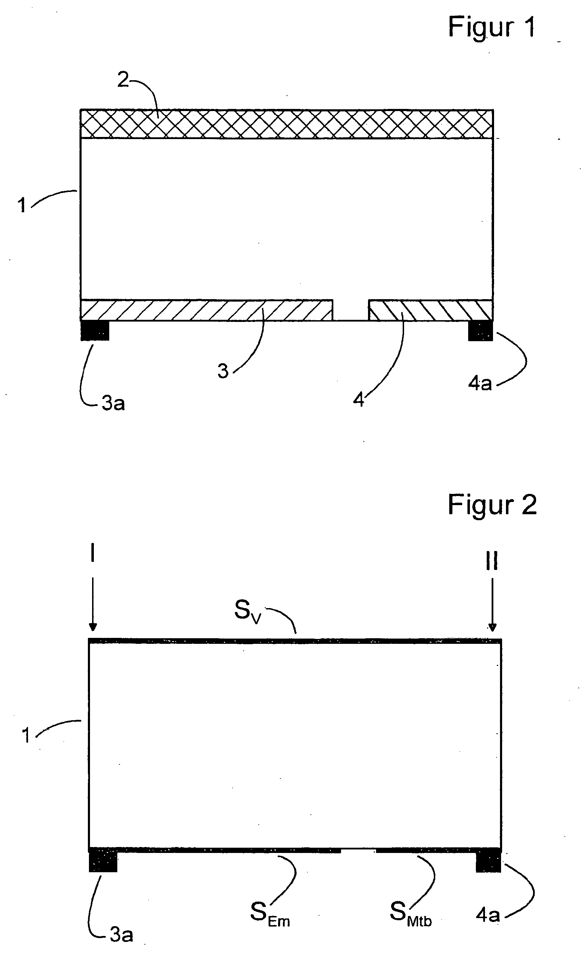

In Figur 1 ist solch eine Rückseitenkontaktzelle schematisch dargestellt. Die Solarzelle besteht aus einem n-dotierten Siliziumwafer, d.h. besitzt eine n-dotierte Basis 1. An der Vorderseite der Solarzelle befindet sich ein die gesamte Vorderseite bedeckender Bereich, der eine Vorderseitendotierung 2, d.h. eine homogene n-Dotierung in hoher Konzentration gegenüber der Basisdotierung aufweist.

Durch diese Hochdotierung an der Vorderseite verringert sich die Rekombinationsgeschwindigkeit bezüglich der Minoritätsladungsträger in der Basis an der Vorderseite, d.h. der Vorderseite kann eine geringe, homogene effektive Rekombinationsgeschwindigkeit zugeordnet werden.

An der Rückseite der Solarzelle befindet sich ein Referenzteilbereich, der durch einen p-dotierten Emitter 3 bedeckt ist. Der Emitter 3 ist mit einer metallischen Emitterkontaktierung 3A verbunden, mittels derer Ladungsträger in den Emitter 3 zu- und abgeführt werden können.

Ebenso weist die Rückseite der In Figur 1 dargestellten Solarzelle einen Messteilbereich auf, welcher in dieser Ausgestaltung der Rückseitenkontaktzelle als n-dotierter Rückseitenbereich 4 mit einer hohen n-Dotierung gegenüber der n-dotierten Basis ausgebildet ist. An der Rückseite der Solarzelle ist ferner eine metallische Basiskontaktierung 4a angeordnet, welche elektrisch leitend mit dem hochdotierten Rückseitenbereich 4 verbunden ist, so dass entsprechend Ladungsträger in dem hochdotierten Rückseitenbereich 4 und die Basis 1 zu- und abgeführt werden können. Zwischen Emitter 3 und Basis 1 bildet sich ein pn-Übergang aus.

Ebenso liegt es im Rahmen der Erfindung, das erfindungsgemäße Verfahren an Solarzellen mit vertauschten Dotierungstypen durchzuführen, d.h. mit p-dotierter Basis und n-dotiertem Emitter.

Die in Figur 1 dargestellte schematische Darstellung zeigt ein so genanntes Symmetrieelement einer Rückseitenkontaktzelle, d.h. lediglich einen Ausschnitt einer gesamten Zelle. Die gesamte Rückseitenkontaktsolarzelle ist durch mehrmalige Spiegelung in Figur 1 nach rechts und links des dargestellten Symmetrieelements denkbar. Die metallischen Kontaktierungen 3a und 4a grenzen unmittelbar an die rechte bzw, linke Spiegelachse an, so dass in Figur 1 nur die Hälfte der tatsächlichen Breite der Kontaktierungen dargestellt ist.

Zur Bestimmung der effektiven Oberflächenrekombinationsgeschwindigkeit im Bereich des hochdotierten Rückseitenbereiches 4 ist insbesondere die Messung von in der Basis 1 erzeugter Lumineszenzstrahlung vorteilhaft, denn aufgrund der hohen Dotierung der Bereiche 2, 3 und 4 findet in diesen hochdotierten Bereichen die Rekombination im Wesentlichen über nicht-strahlende Rekombinationsprozesse statt, d.h. bei der Rekombination in diesen Bereichen wird keine Lumineszenzstrahlung erzeugt. Die von der Solarzelle abgestrahlte Lumineszenzstrahlung entsteht somit im Wesentlichen in der Basis, so dass die Messung nur vernachlässigbar gering durch in anderen Bereichen entstehende Lumineszenzstrahlung beeinflusst wird.

Als für die Messung der Intensität der Photolumineszenzstrahlung aktive Struktur kann deshalb näherungsweise das in Figur 2 dargestellte Symmetrieelement verwendet werden.

Bei diesem Symmetrieelement gemäß Figur 2 sind die hochdotierten Bereiche 2,3,4 durch Oberflächenbereiche an Vorder- und Rückseite der Basis ersetzt, welche lediglich effektive Oberflächenrekombinationsgeschwindigkeiten zugeordnet werden: Die Rekombinationsgeschwindigkeit der Vorderseite kann somit durch eine effektive Oberflächenrekombinationsgeschwindigkeit $S_v$ der durch den Emitter bedeckte Teilbereich der Rückseite durch eine effektive Oberflächenrekombinationsgeschwindigkeit $S_{Em}$ und die zur Bestimmung der effektiven Oberflächenrekombinationsgeschwindigkeit in dem Teilbereich mit hoher n-Dotierung kann durch eine Oberflächenrekombinationsgeschwindigkeit $S_{Mtb}$ beschrieben werden. Der hochdotierte Bereich 4 an der Rückseite der Rückseitenkontaktzelle stellt den Messteilbereich dar.

Die Vorderseite der Rückseitenkontaktzelle wird nun gemäß Verfahrensschritt A ganzflächig mit Anregungsstrahlung beaufschlagt. Vorteilhafterweise wird hierzu eine durch einen Laser erzeugte monochromatische Strahlung mit einer Wellenlänge zwischen 750 nm und 1120 nm verwendet, insbesondere zwischen 790 nm und 940 nm. Diese Werte sind insbesondere bei Verwendung des erfindungsgemäßen Verfahrens zur Messung an Siliziumhalbleitern vorteilhaft. Grundsätzlich ist eine homogene Generation in der Halbleiterstruktur durch die Anregungsstrahlung vorteilhaft, dies kann insbesondere durch Verwendung von Anregungsstrahlung mit einer Wellenlänge nahe der Bandkante des Untersuchten Halbleiters erwirkt werden.

Um Verfälschungen durch die metallischen Kontakte an der Rückseite der Halbleiterstruktur zu vermeiden, wird mittels eines Detektors die von der Vorderseite der Solarzelle abgestrahlte Intensität der Lumineszenzstrahlung in den in Figur 2 mit I und II gekennzeichneten Bereichen gemessen. Aufgrund der Spiegelung des In Figur 1 und 2 dargestellten Symmetrieelementes an der rechten und linken Spiegelachse befindet sich Bereich I somit etwa mittig über dem Emitter 3 und Bereich II etwa mittig über Rückseitenbereich 4.

Hierbei kann auf an sich bekannte Messaufbauten zur Messung der Intensität von Lumineszenzstrahlung bei Solarzellen zurückgegriffen werden. Insbesondere ist es bekannt, eine CCD-Kamera zur ortsaufgelösten Vermessung der Lumineszenzstrahlung zu verwenden und mittels eines optischen Langpassfilters, welcher im Strahlengang zwischen Vorderseite der Solarzelle und CCD-Kamera angeordnet ist, eine eventuelle Reflektion der Anregungsstrahlung von der Vorderseite der Solarzelle in Richtung Kamera auszublenden, so dass keine oder nur eine geringe Verfälschung des Messergebnisses durch die reflektierte Anregungsstrahlung erfolgt.

Die Verwendung einer CCD-Kamera zur Messung der Intensität von Lumineszenzstrahlung bei Solarzellen ist beispielsweise in Würfel, p. et al, "Diffusions lengths of silicon solar cells from luminescence images", Journal of Applied Physics, 2007. 101 (123110). p. 1-10 und in PCT/AU2007/001050 beschrieben.

Anschließend wird gemäß Verfahrensschritt C eine äußere Spannung zwischen metallischem Emitterkontakt und metallischem Basiskontakt angelegt und hierdurch ein Stromfluss in der Solarzelle erzeugt. Die äußere Spannung wird dabei ausgehend von 0 Volt erhöht, bis die gemessene Lumineszenzintensität im Basisbereich über dem Emitter 3 der gemessenen Lumineszenzintensität im Basisbereich über der Hochdotierung 4, d.h. über dem Messteilbereich entspricht.

Das hierdurch bestimmte Wertepaar aus äußerer Spannung und bei dieser Spannung beispielsweise am Emitterkontakt fließenden Strom ermöglicht gemäß Formel A oder Formel B die Berechnung der effektiven Oberflächenrekombinationsgeschwindigkeit $S_{Mtb}$.

## Patentansprüche

1. Verfahren zur Bestimmung der Rekombinationseigenschaften an einem Messteilbereich einer Messseite einer Halbleiterstruktur,
   wobei die Halbleiterstruktur eine Basis (1) umfasst und an der Messseite zumindest den Messteilbereich und einen Referenzteilbereich, welcher zur Zu- oder Abführung von Ladungsträgern ausgebildet ist, aufweist, wobei der Referenzteilbereich durch einen Emitter bedeckt ist und der Messteilbereich nicht durch einen Emitter bedeckt ist, und das Verfahren folgende Verfahrensschritte umfasst:

   A Erzeugen von Überschussminoritätsladungsträgern zumindest in der Basis (1) der Halbleiterstruktur,
   B Messen der Überschussladungsträgerdichte in der Basis (1) oder einer zumindest qualitativ mit der Überschussladungsträgerdichte korrespondierenden Größe, wobei zumindest eine erste Messung $M_1$ an einem über dem Referenzteilbereich liegenden ersten Basisbereich und eine zweite Messung $M_2$ an einem Ober dem Messteilbereich liegenden zweiten Basisbereich durchgeführt wird,
   C Erzeugen eines Stromflusses / in der Halbleiterstruktur bei einer äußeren Spannung V zwischen dem Referenzteilbereich und einem mit der Basis (1) der Halbleiterstruktur verbundenen Basiskontakt, wobei die äußere Spannung V oder der Strom f derart gewählt wird, dass das Messergebnisse der ersten Messung $M_1$ gleich dem Messergebnis der zweiten Messung $M_2$ ist und
   D Bestimmen der Rekombinationseigenschaften des Messteilbereiches der Halbleiteroberfläche abhängig von der anliegenden äußeren Spannung V und dem zwischen dem Referenzteilbereich und dem Basiskontakt fließenden Strom $I$.

2. Verfahren nach Anspruch 1,
   **dadurch gekennzeichnet,**
   **dass** in Verfahrensschritt A die Überschussminoritätsladungsträger durch Beaufschlagung der Hableiterstruktur mit einer Anregungsstrahlung erzeugt werden, insbesondere durch ganzflächiges, homogenes Beleuchten einer Oberfläche der Halbleiterstruktur mit Anregungsstrahlung.

3. Verfahren nach mindestens einem der vorangegangenen Ansprüche,
   **dadurch gekennzeichnet,**
   **dass** in Schritt B bei den Messungen $M_1$ und $M_2$ die Intensität der Lumineszenzstrahlung der jeweiligen Bereiche gemessen wird.

4. Verfahren nach mindestens einem der vorangegangenen Ansprüche,
   **dadurch gekennzeichnet,**
   **dass** bei der Halbleiterstruktur der Referenzteilbereich der Halbleiteroberfläche durch einen Emitter 3 bedeckt ist, zur Ausbildung eines pn-Überganges mit der Basis (1) der Halbleiterstruktur, insbesondere, dass der Emitter 3 auf der Halbleiteroberfläche mit einem Metallkontakt kontaktiert ist.

5. Verfahren nach mindestens einem der vorangegangenen Ansprüche 1 bis 3,
   **dadurch gekennzeichnet,**
   **dass** bei der Halbleiterstruktur an dem Referenzteilbereich auf der Halblelteroberfläche einen Metallkontakt zur Ausbildung eines Schottky-Kontaktes angeordnet ist.

6. Verfahren nach mindestens einem der vorangegangenen Ansprüche 1 bis 3,
   **dadurch gekennzeichnet,**
   **dass** bei der Halbleiterstruktur an dem Referenzteilbereich auf Halbleiteroberfläche ein Dielektrikum und Metallkontakt zur Ausbildung eines MOS- oder MIS-Kontaktes angeordnet ist.

7. Verfahren nach mindestens einem der vorangegangenen Ansprüche 1 bis 3,
   **dadurch gekennzeichnet,**
   **dass** bei der Halbleiterstruktur an dem Referenzteilbereich auf der Halbleiferoberfläche ein weiterer Halbleiter angeordnet ist, zur Ausbildung eines Hetero-Kontaktes.

8. Verfahren nach mindestens einem der vorangegangenen Ansprüche,
   **dadurch gekennzeichnet,**
   **dass** die Basis (1) der Halbleiterstruktur eine im Wesentlichen homogene Minoritätsladungsträgerlebensdauer aufweist.

9. Verfahren nach mindestens einem der vorangegangenen Ansprüche,
   **dadurch gekennzeichnet,**
   **dass** die Halbeiterstruktur an der der Messseite gegenüberliegenden Seite im Wesentlichen homogene Rekombinationseigenschaften aufweist.

10. Verfahren nach mindestens einem der vorangegangenen Ansprüche,
    **dadurch gekennzeichnet,**
    **dass** die Halbleiterstruktur als Rückseitenkontaktsolarzelle ausgebildet ist, insbesondere als auf einem Siliziumwafer basierende Rückseitenkontaktsolarzelle.

11. Verfahren nach mindestens einem der vorangegangenen Ansprüche,
    **dadurch gekennzeichnet,**
    **dass** die Halbleiterstruktur an der der Messseite gegenüberliegenden Seite einen Bereich des gleichen Dotierungstyps wie die Basis (1), jedoch mit höherer Dotierkonzentration gegenüber der Basis (1) aufweist.

12. Verfahren nach mindestens einem der vorangegangenen Ansprüche 1 bis 10,
    **dadurch gekennzeichnet,**
    **dass** die Halbleiterstruktur an der der Messseite gegenüberliegenden Seite einen Bereich des entgegengesetzten Dotierungstyps wie die Basis (1), jedoch mit höherer Dotierkonzentration gegenüber der Basis (1) aufweist.

13. Verfahren nach mindestens einem der vorangegangenen Ansprüche,
    **dadurch gekennzeichnet,**
    **dass** in Verfahrensschritt D die Rekombinationseigenschaften des Messteilbereiches der Halbleiteroberfläche durch Berechnen der Oberflächenrekombinationsgeschwindigkeit $S_{Mtb}$ über folgende Formel A bestimmt werden:

$$S_{Mtb} = \frac{j\,N_D}{e\,n_i^2} \exp\left(-\frac{e\,V}{k\,T}\right) \quad \text{(Formel A)},$$

mit dem gemessenen, zwischen Referenzteilbereich und Basiskontakt fließenden Strom $j$, der Dotierkonzentration der Basis $N_D$, der Elementarladung e, der intrinsischen Dichte $n_{i1}$ der zwischen Referenzteilbereich und Basiskontakt anliegenden äußeren Spannung V, der Boltzmannkonstante $k$ und der Temperatur T der Halbleiterstruktur.

**14.** Verfahren nach Anspruch 13,
**dadurch gekennzeichnet,**
**dass** bei Berechnen der Oberflächenrekombinationsgeschwindigkeit $S_{Mtb}$ zusätzlich der Serienwiderstand der Halbleiterstruktur berücksichtigt wird und die Berechnung über Formel B erfolgt:

$$S_{Mtb} = \frac{j\, N_{t_2}}{e\, n_i^2} \exp\left( -\frac{e\left(V + j\, R_S\right)}{k\, T} \right) \quad (\text{Formel B}),$$

mit dem Gesamtserienwiderstand $R_S$ der Halbleiterstruktur zwischen Referenzteilbereich und Basiskontakt.

**15.** Verfahren nach mindestens einem der vorangegangenen Ansprüche,
**dadurch gekennzeichnet,**
**dass** in Verfahrensschritt B die Messung der Überschussladungsträgerdichte Im quasi-statischen Zustand der Halbleiterstruktur erfolgt.

## Claims

**1.** A method of determining the recombination properties at a measuring section of a measuring side of a semiconductor structure, wherein the semiconductor structure includes a base (1) and, on the measuring side, has at least the measuring section and a reference section, which is constructed for the supply or removal of charge carriers, wherein the reference section is covered by an emitter and the measuring section is not covered by an emitter and the method includes the following method steps:

A producing surplus minority charge carriers at least in the base (1) of the semiconductor structure,
B measuring the surplus charge carrier density in the base or a parameter corresponding at least qualitatively with the excess charge carrier density, wherein at least a first measurement $M_1$ is performed on a first base region situated above the reference section and a second measurement $M_2$ on a second base section situated above the measuring section,
C producing a current flow / in the semiconductor structure with an external voltage V between the reference section and a base contact connected to the base (1) of the semiconductor structure, wherein the external voltage V or the current / is so selected that the measuring result of the first measuring $M_1$ is equal to the measurement result of the second measurement $M_2$ *and*
D determining the recombination properties of the measuring section of the semiconductor surface in dependence on the applied external voltage V and the current / flowing between the reference section and the base contact.

**2.** A method as claimed in Claim 1, **characterised in that** in method step A the surplus minority charge carriers are produced by the application to the semiconductor structure of an excitation radiation, particularly by the homogenous illumination over the entire area of a surface of the semiconductor structure with excitation radiation.

**3.** A method as claimed in at least one of the preceding claims, **characterised in that** in step B the intensity of the luminescence radiation of the respective regions is measured in the measurements $M_2$ and $M_2$.

**4.** A method as claimed in at least one of the preceding claims, **characterised in that** in the semiconductor structure the reference section of the semiconductor surface is covered by an emitter (3) to form a pn junction with the base (1) of the semiconductor structure, particularly that the emitter (3) on the semiconductor surface is contacted by a metal contact.

**5.** A method as claimed in at least one of the preceding Claims 1 to 3, **characterised in that** in the semiconductor structure a metal contact for forming a Schottky contact is arranged on the reference section on the semiconductor surface.

**6.** A method as claimed in at least one of the preceding Claims 1 to 3, **characterised in that** in the semiconductor structure a dielectric and metal contact for forming an MOS or MIS contact is arranged on the reference section on the semiconductor surface.

7. A method as claimed in at least one of the preceding Claims 1 to 3, **characterised in that** in the semiconductor structure a further semiconductor for forming a hetero-contact is arranged on the reference section on the semiconductor surface.

8. A method as claimed in at least one of the preceding claims, **characterised in that** the base (1) of the semiconductor structure has a substantially homogeneous minority charge carrier life.

9. A method as claimed in at least one of the preceding claims, **characterised in that** on the side opposite to the measuring side the semiconductor structure has substantially homogeneous recombination properties.

10. A method as claimed in at least one of the preceding claims, **characterised in that** the semiconductor structure is constructed in the form of a rear contact solar cell, particularly in the form of a rear contact solar cell based on a silicon wafer.

11. A method as claimed in at least one of the preceding claims, **characterised in that** on the side opposite to the measuring side the semiconductor structure has a region of the same dosing type as the base (1) but with a higher dosing concentration by comparison with the base (1).

12. A method as claimed in at least one of the preceding Claims 1 to 10, **characterised in that** on the side opposite to the measuring side the semiconductor structure has a region of the opposite dosing type to the base (1) but with a higher dosing concentration by comparison with the base (1).

13. A method as claimed in at least one of the preceding claims, **characterised in that** in method step D the recombination properties of the measuring section of the semiconductor surface are determined by calculating the surface recombination velocity $S_{Mtb}$ by means of the following formula A:

$$S_{Mtb} = \frac{j \, N_D}{e \, n_i^2} \exp\left(-\frac{e\,V}{k\,T}\right) \qquad \text{(Formula A)}$$

with the measured current $j$ flowing between the reference section and base contact, the dosing concentration of the base $N_D$, the elementary charge e, the intrinsic density $n_i$ of the external voltage V between the reference section and base contact, the Boltzmann constant $k$ and the temperature T of the semiconductor structure.

14. A method as claimed in Claim 13, **characterised in that** when calculating the surface recombination velocity $S_{Mtb}$ the series resistance of the semiconductor structure is additionally taken into account and the calculation is effected by means of formula B:

$$S_{Mtb} = \frac{j \, N_D}{e \, n_i^2} \exp\left(-\frac{e\,(V + j\,R_S)}{k\,T}\right) \qquad \text{(Formula B)}$$

with the total series resistance $R_S$ of the semiconductor structure between the reference section and base contact.

15. A method as claimed in at least one of the preceding claims, **characterised in that** in method step B the measurement of the surplus charge carrier density is effected in the quasi-static state of the semiconductor structure.

**Revendications**

1. Procédé pour déterminer les propriétés de recombinaison sur une zone partielle de mesure d'un côté de mesure d'une structure semi-conductrice,
la structure semi-conductrice comprenant une base (1) et présentant, du côté de mesure, au moins la zone partielle de mesure et une zone partielle de référence, laquelle est conçue pour amener ou évacuer des porteurs de charge, la zone partielle de référence étant recouverte par un émetteur et la zone partielle de mesure n'étant pas couverte par un émetteur, lequel procédé comprend les étapes consistant à :

A générer des porteurs de charge minoritaires excédentaires au moins dans la base (1) de la structure semi-conductrice,
B mesurer la densité de porteurs de charge excédentaires dans la base (1) ou une grandeur correspondant au moins qualitativement à la densité de porteurs de charge excédentaires, au moins une première mesure $M_1$ étant effectuée sur une première zone de base située au-dessus de la zone partielle de référence et une deuxième mesure $M_2$ sur une deuxième zone de base située au-dessus de la zone partielle de mesure,
C générer un flux de courant $I$ dans la structure semi-conductrice à une tension extérieure $V$ entre la zone partielle de référence et un contact de base relié à la base (1) de la structure semi-conductrice, la tension extérieure V ou le courant $I$ étant choisi(e) de telle manière que le résultat de la première mesure $M_1$ soit égal au résultat de la deuxième mesure $M_2$ et
D déterminer les propriétés de recombinaison de la zone partielle de mesure de la surface semi-conductrice en fonction de la tension extérieure V appliquée et du courant $I$ circulant entre la zone partielle de référence et le contact de base.

2. Procédé selon la revendication 1,
**caractérisé en ce**
**qu'**à l'étape de procédé A, les porteurs de charge minoritaires excédentaires sont générés en soumettant la structure semi-conductrice à un rayonnement d'excitation, en particulier en exposant en pleine surface, de manière homogène, une surface de la structure semi-conductrice à un rayonnement d'excitation.

3. Procédé selon au moins l'une des revendications précédentes,
**caractérisé en ce**
**qu'**à l'étape B, lors des mesures $M_1$ et $M_2$, l'intensité du rayonnement luminescent des zones respectives est mesurée.

4. Procédé selon au moins l'une des revendications précédentes,
**caractérisé en ce**
**que** sur la structure semi-conductrice, la zone partielle de référence de la surface semi-conductrice est recouverte par un émetteur 3 pour former une jonction pn avec la base (1) de la structure semi-conductrice, en particulier que l'émetteur 3 sur la surface semi-conductrice est mis en contact avec un contact métallique.

5. Procédé selon au moins l'une des revendications précédentes 1 à 3,
**caractérisé en ce**
**que** sur la structure semi-conductrice, un contact métallique est disposé sur la zone partielle de référence de la surface semi-conductrice pour former un contact Schottky.

6. Procédé selon au moins l'une des revendications précédentes 1 à 3,
**caractérisé en ce**
**que** sur la structure semi-conductrice, un diélectrique et un contact métallique sont disposés sur la zone partielle de référence de la surface semi-conductrice pour former un contact MOS ou MIS.

7. Procédé selon au moins l'une des revendications précédentes 1 à 3,
**caractérisé en ce**
**que** sur la structure semi-conductrice, un autre semi-conducteur est disposé sur la zone partielle de référence de la surface semi-conductrice pour former un hétérocontact.

8. Procédé selon au moins l'une des revendications précédentes,
**caractérisé en ce**
**que** la base (1) de la structure semi-conductrice présente une durée de vie des porteurs de charge minoritaires sensiblement homogène.

9. Procédé selon au moins l'une des revendications précédentes,

**caractérisé en ce**
**que** la structure semi-conductrice présente des propriétés de recombinaison sensiblement homogènes du côté opposé au côté de mesure.

10. Procédé selon au moins l'une des revendications précédentes,
**caractérisé en ce**
**que** la structure semi-conductrice est réalisée sous la forme d'une cellule solaire à contact arrière, en particulier sous la forme d'une cellule solaire à contact arrière basée sur une plaquette de silicium.

11. Procédé selon au moins l'une des revendications précédentes,
**caractérisé en ce**
**que** la structure semi-conductrice présente du côté opposé au côté de mesure une zone de même type de dopage que la base (1), mais avec une concentration de dopage plus élevée par rapport à la base (1).

12. Procédé selon au moins l'une des revendications précédentes 1 à 10,
**caractérisé en ce**
**que** la structure semi-conductrice présente du côté opposé au côté de mesure une zone de type de dopage opposé à celui de la base (1), mais avec une concentration de dopage plus élevée par rapport à la base (1).

13. Procédé selon au moins l'une des revendications précédentes,
**caractérisé en ce**
**qu'**à l'étape de procédé D, les propriétés de recombinaison de la zone partielle de mesure de la surface semi-conductrice sont déterminées en calculant la vitesse de recombinaison en surface $S_{Mtb}$ au moyen de la formule A suivante :

$$S_{Mtb} = \frac{jN_D}{en_i^2}\exp\left(-\frac{eV}{kT}\right) \text{ (formule A),}$$

avec le courant j qui circule entre la zone partielle de référence et le contact de base, la concentration de dopage de la base $N_D$, la charge élémentaire $e$, la densité intrinsèque $n_i$, la tension extérieure V appliquée entre la zone partielle de référence et le contact de base, la constante de Boltzmann $k$ et la température T de la structure semi-conductrice.

14. Procédé selon la revendication 13,
**caractérisé en ce**
**que** lors du calcul de la vitesse de recombinaison en surface $S_{Mtb}$, il est en outre tenu compte de la résistance série de la structure semi-conductrice et le calcul est effectué au moyen de la formule B :

$$S_{Mtb} = \frac{jN_D}{en_i^2}\exp\left(-\frac{e(V + jR_S)}{kT}\right) \text{ (formule B),}$$

avec la résistance série totale $R_S$ de la structure semi-conductrice entre la zone partielle de référence et le contact de base.

15. Procédé selon au moins l'une des revendications précédentes,
**caractérisé en ce**
**qu'**à l'étape de procédé B, la mesure de la densité de porteurs de charge excédentaires est effectuée en régime quasi statique de la structure semi-conductrice.

Figur 1

Figur 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5406214 A

- AU 2007001050 W

**In der Beschreibung aufgeführte Nicht-Patentliteratur**

- **R.A. SINTON ; A.CUEVAS ; M . STUCKINGS.** Quasi-steady-state photoconductance, a new method for solar cell material and device characterization. *Proceedings for the 25th IEE Photovoltaic Specialists Conference,* 1996
- **E.O. JOHNSON.** Measurement of Minority Carrier Lifetimes with the Surface Photovoltage. *Journal of Applied Physics,* vol. 28 (11), 1349-53
- **WÜRFEL, T. et al.** Diffusions lengths of silicon solar cel/s from luminescence images. *journal of applied physics,* 2007, vol. 101 (123110), 1-10

- **WÜRFEL, P. et al.** Diffusions lengths of silicon solar cells from luminescence images. *Journal of Applied Physics,* 2007, vol. 101 (123110), 1-10
- **PYSCH, D. ; A. METTE ; S. W. GLUNZ.** A review and comparison of different methods to determine the series resistance of solar cells. *Solar Energy Materials and Solar Cells,* 2007, vol. 91 (18), 1698-1706